# EUROPÄISCHE PATENTANMELDUNG

(11) **EP 1 133 224 A2**
(43) Veröffentlichungstag der Anmeldung: **12.09.2001**
(21) Anmeldenummer: 01104818.8
(22) Anmeldetag: 27.02.2001
(51) Int. Cl.: H05K 9/00

(54) **Bus-Transceiver mit Abschirmgehäuse sowie Abschirmgehäuse für einen Bus-Transceiver**

(30) Priorität: 10.03.2000 DE 10011463
(71) Anmelder: ABB PATENT GmbH, 68309 Mannheim (DE)
(72) Erfinder: Mühlbauer, Bernd, 69121 Heidelberg (DE)
(74) Vertreter: Miller, Toivo

(57) **Zusammenfassung**

Die Erfindung bezieht sich auf einen gegen elektromagnetische Störfelder geschirmten Bus-Transceiver (2), sowie auf ein Abschirmgehäuse (1) zur Aufnahme eines Bus-Tranceivers (2) einschließlich Übertrager (8). Das Gehäuse (1) hat einen haubenförmigen Deckel (3) und eine damit verlötete Bodenplatte (4) aus einem magnetischen Material. Innerhalb des Gehäuses (1) ist ein Fassungsteil (10) angeordnet.

## Beschreibung

Die Erfindung bezieht sich auf einen geschirmten Bus-Transceiver, sowie auf ein Abschirmgehäuse zur Aufnahme eines Bus-Tranceivers einschließlich Übertrager.

Die Erfindung läßt sich insbesondere anwenden, um eine gute Schirmung von Bus-Transceivern einschließlich Übertragern, also von Sendeempfangs-Einrichtungen, gegen elektromagnetische Störfelder zu erreichen. Besonders schwierig ist eine Abschirmung elektromagnetischer Störfelder, die von Kabelverbindungen zwischen einem Frequenz-Umrichter und einem Elektromotor ausgehen. Bus-Transceiver, die im Bereich solcher Anordnungen eingesetzt sind, können nur dann störungsfrei arbeiten, wenn eine wirksame Abschirmung erreicht wird.

Unter Bus-Transceiver werden integrierte Bausteine verstanden, wie beispielsweise der Lonworks Bus-Transceiver FTT-10A Model 50051, der von der Firma Echelon angeboten wird.

Allgemein bekannte Abschirmungen aus elektrisch leitendem Material, insbesondere aus Kupfer, die zur Abschirmung gegen hochfrequente elektromagnetische Störfelder eingesetzt werden, haben sich im dargelegten Anwendungsfall als nahezu unwirksam erwiesen. Die Störfrequenzen liegen nämlich in diesem Fall in einem unteren Frequenzbereich, bis zu einer oberen Frequenz von etwa 10 MHz.

In dem Bestreben, eine Beeinflussung des Bus-Transceivers im niederfrequenten Bereich zu verhindern, bietet die Firma Echelon für ihren Transceiver Model 50051 eine Abschirmhaube aus einem magnetischen Material an.

Versuche haben gezeigt, daß auch mit dieser Maßnahme keine befriedigende Abschirmung erreicht wird. Eine Ursache ist darin zu sehen, daß Feldlinien in das Innere der Abschirmhaube ausbauchen und damit elektronische Schaltungen und Übertrager beeinflussen können.

Der Erfindung liegt daher die Aufgabe zugrunde, einen besser geschirmten Bus-Transceiver, sowie ein Abschirmgehäuse zur Aufnahme eines Bus-Tranceivers einschließlich Übertrager anzugeben.

Diese Aufgabe wird durch einen Bus-Transceiver bzw. ein Abschirmgehäuse zur Aufnahme eines Bus-Tranceivers einschließlich Übertrager gelöst, der bzw. das die im Anspruch 1 bzw. 15 angegebenen Merkmale aufweist. Vorteilhafte Ausgestaltungen, insbesondere ein innerhalb der Abschirmung einsetzbarer Fassungsteil, sind in weiteren Ansprüchen angegeben.

Mit der Erfindung wird im wesentlichen vorgeschlagen, ein Abschirmgehäuse zu verwenden, das nicht nur eine Haube, sondern auch einen Boden aus magnetischem Material hat, und vorzugsweise durch Verlöten der beiden Teile vollständig geschlossen ist.

Es wird damit auf kostengünstige Weise erreicht, daß eine Beeinflussung von Übertragungssignalen allein durch Schirmung des Bus-Transceivers einschließlich eines üblicherweise eingesetzten Übertragers vermieden wird, und somit eine Schirmung der Störquelle oder der Steuerungselektronik eines Frequenz-Umrichters entbehrlich ist.

Eine weitere Beschreibung der Erfindung und deren Vorteile erfolgt nachstehend anhand eines in Zeichnungsfiguren dargestellten Ausführungsbeispiels.

Es zeigen:
- Fig. 1: einen Schnitt durch und eine Draufsicht auf einen geschirmten Bus-Transceiver,
- Fig. 2: eine Draufsicht auf eine Bodenplatte, und
- Fig. 3: einen Schnitt durch einen geschirmten Bus-Transceiver mit einer alternativen Isolierung von Anschlußstiften.

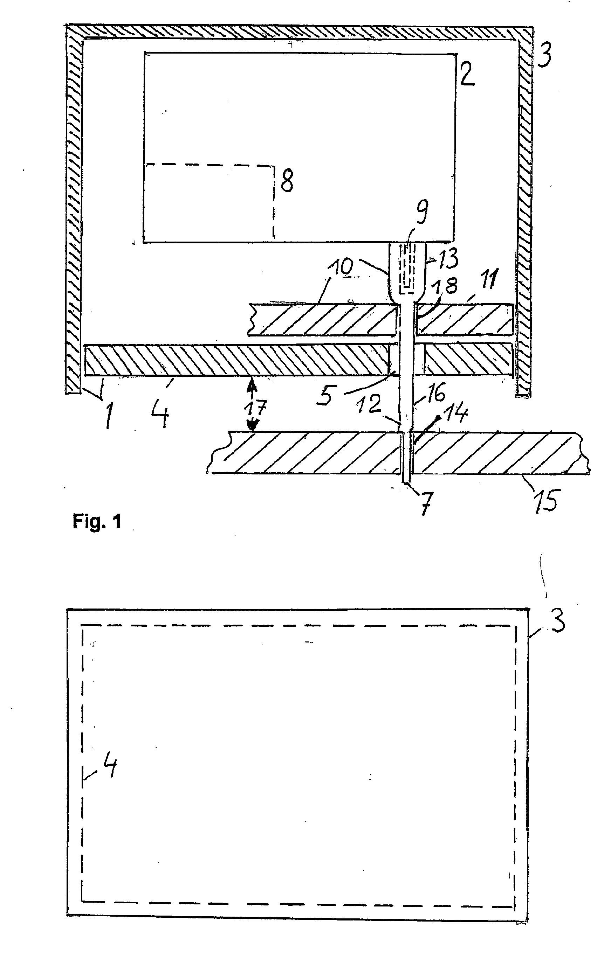

Fig. 1 zeigt eine Anordnung, bei der ein Bus-Transceiver 2 einschließlich eines Übertragers 8 in einem Abschirmgehäuse 1 angeordnet ist, das durch einen haubenförmigen Deckel 3 und eine damit verlötete Bodenplatte 4 aus magnetischem Material, vorzugsweise Stahlblech, gebildet ist. Der so geschirmte Bus-Transceiver 1,2 weist Anschlüsse 7 auf. Mittels der Anschlüsse 7 ist der geschirmte Bus-Transceiver 1,2 in Anschlußöffnungen 14 einer Leiterplatte 15 eingesteckt und gegebenenfalls mit deren Leiterbahnen verlötet.

Sowohl der Deckel 3, als auch die Bodenplatte 4 sind aus einem magnetischen Stahlblech mit einer Blechdicke im Bereich von 0,1 mm bis 1,0 mm, vorzugsweise 0,5 mm hergestellt.

Der Bus-Transceiver 1 hat Anschlußbeine 9, mit denen er in einen Fassungsteil 10 eingesteckt ist. Der Fassungsteil 10 ist zwischen die mit den Anschlußbeinen 9 versehene Unterseite des Bus-Transceivers 1 und die Bodenplatte 4 eingesetzt. Der Fassungsteil 10 weist eine Lochplatte 11 aus elektrisch isolierenden Material auf, in deren mehrere Öffnungen 18 jeweils metallische Fassungsstreifen 12 eingesetzt sind. Die Fassungsstreifen 12 haben jeweils an einem - in der Zeichnung oberen - Ende eine Fassung 13 zur Aufnahme eines der Anschlußbeine 9. Am anderen Ende ist jeweils der Anschluß 7 angeformt, zum Einstecken des geschirmten Bus-Transceivers 1,2 in die Anschlußöffnungen 14 in Leiterbahnen der Leiterplatte 15.

Die Anschlüsse 7 der Fassungsstreifen 12 weist jeweils eine Erweiterung 16 auf, mit deren Hilfe zur elektrischen Isolierung ein Abstand 17 zwischen dem geschirmten Bus-Transceiver 1,2 und Leiterbahnen der Leiterplatte 15 erreicht ist.

Die Abmessungen der Bodenplatte 4 sind so gewählt, daß sie in den haubenförmigen Deckel 3 einsetzbar ist, und - vor dem Verlöten - darin verschiebbar ist. Dadurch sind Bauhöhenunterschiede des jeweils einzusetzenden Bus-Transceivers mit Übertrager ausgleichbar und eine Fixierung des Bus-Transceivers innerhalb des Gehäuses 3,4 ermöglicht..

Um eine gute Verlötbarkeit der Blechteile 3,4 zu erzielen, sind diese verzinnt.

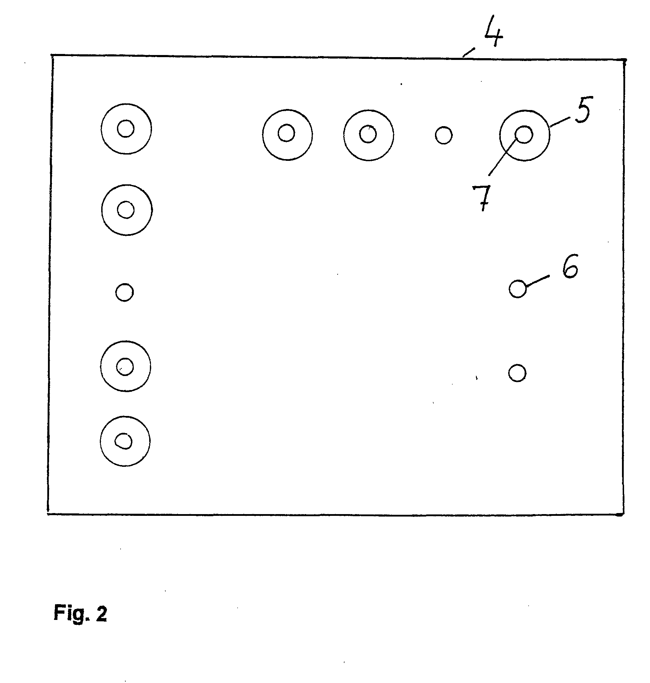

Fig. 2 zeigt mehrere erste Bohrungen 5 der Bodenplatte 4, die mit einem so großen Durchmesser ausgeführt sind, daß ein isolierender Abstand zwischen Anschluß 7 und Bodenplatte 4 besteht, wobei die notwendige Zentrierung des jeweiligen Anschlusses 7 durch die Lochplatte 11 (s. Fig. 1) sichergestellt ist.

In engere zweite Bohrungen 6 der Bodenplatte 4 sind solche Anschlüsse 7 paßgenau einsetzbar, die z.B. als Masseanschlüsse elektrisch kontaktiert werden sollen, oder die ohne elektrische Funktion zur Justierung und Fixierung angeordnet sind.

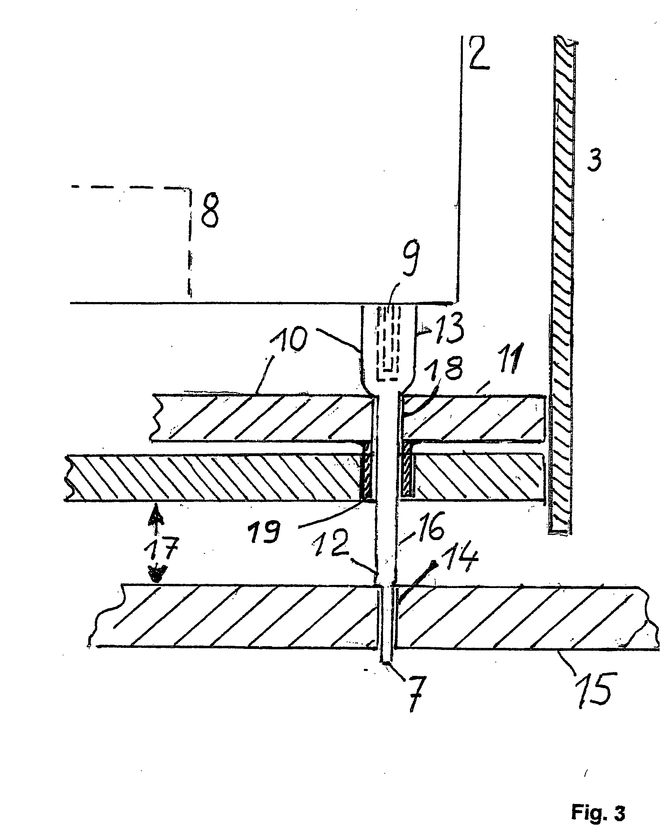

Fig. 3 zeigt einen Schnitt durch einen geschirmten Bus-Transceiver entsprechend Fig. 1, jedoch mit einer alternativen elektrischen Isolierung der Anschlußstifte 7. Diese Isolierung wird durch Isolierteile 19 erreicht, die an die Lochplatte 11 angeformt sind und in die Anschlußöffnungen 14 ragen.

## Patentansprüche

1. Bus-Transceiver (2) mit Abschirmgehäuse (1), wobei das Gehäuse (1) einen haubenförmigen Deckel (3) aus einem magnetischen Material aufweist, **dadurch gekennzeichnet, daß** das Gehäuse (1) außerdem eine Bodenplatte (4) aus einem magnetischen Material aufweist, die elektrisch leitend mit dem Deckel (3) verbunden ist.

2. Bus-Transceiver nach Anspruch 1, **dadurch gekennzeichnet, daß** das magnetische Material des Gehäuses (1) ein magnetisches Stahlblech ist.

3. Bus-Transceiver nach einem der vorstehenden Ansprüche, **dadurch gekennzeichnet, daß** der Deckel (3) und die Bodenplatte (4) verzinnt sind.

4. Bus-Transceiver nach einem der vorstehenden Ansprüche, **dadurch gekennzeichnet, daß** der Deckel (3) und die Bodenplatte (4) zur mechanischen und elektrischen Verbindung miteinander verlötet sind.

5. Bus-Transceiver nach einem der vorstehenden Ansprüche, **dadurch gekennzeichnet, daß** der Deckel (3) und die Bodenplatte (4) aus einem Blech mit einer Dicke im Bereich von 0,1 mm bis 1,0 mm hergestellt sind.

6. Bus-Transceiver nach einem der vorstehenden Ansprüche, **dadurch gekennzeichnet, daß** die Abmessungen der Bodenplatte (4) so gewählt sind, daß sie in den haubenförmigen Deckel (3) einsetzbar und vor dem elektrisch leitenden Verbinden darin verschiebbar ist.

7. Bus-Transceiver nach einem der vorstehenden Ansprüche, **dadurch gekennzeichnet, daß** er einen Übertrager (8) enthält.

8. Bus-Transceiver nach einem der vorstehenden Ansprüche, **dadurch gekennzeichnet, daß** er mit seinen Anschlußbeinen (9) in einen Fassungsteil (10) eingesteckt ist, der zwischen die mit den Anschlußbeinen (9) versehene Unterseite des Bus-Transceivers (1) und die Bodenplatte (4) eingesetzt ist.

9. Bus-Transceiver nach Anspruch 8, **dadurch gekennzeichnet, daß** der Fassungsteil (10) eine Lochplatte (11) aus elektrisch isolierendem Material enthält, in deren Öffnungen (18) mehrere metallische Fassungsstreifen (12) eingesetzt sind.

10. Bus-Transceiver nach Anspruch 9, **dadurch gekennzeichnet, daß** die Fassungsstreifen (12) jeweils an einem Ende eine Fassung (13) zur Aufnahme eines der Anschlußbeine (9) aufweisen, und am anderen Ende einen Anschluß (7) zum Einstecken des geschirmten Bus-Transceivers (1,2) in Anschlußöffnungen (14) einer Leiterplatte (15).

11. Bus-Transceiver nach Anspruch 10, **dadurch gekennzeichnet, daß** die Anschlüsse (7) der Fassungsstreifen (12) jeweils eine Erweiterung (16) aufweisen, mit deren Hilfe ein Abstand (17) zwischen dem geschirmten Bus-Transceiver (1,2) und der Leiterplatte (15) erreicht ist.

12. Bus-Transceiver nach einem der Ansprüche 10 oder 11, **dadurch gekennzeichnet, daß** die Bodenplatte (4) erste Bohrungen (5) zur Durchführung der Anschlüssen (7) aufweist, wobei die ersten Bohrungen (5) so groß ausgeführt sind, daß jeweils eine Luftstrecke zwischen Anschluß (7) und Bodenplatte (4) zur elektrischen Isolierung besteht.

13. Bus-Transceiver nach einem der Ansprüche 10 oder 11, **dadurch gekennzeichnet, daß** an die Lochplatte (11) Isolierteile (19) angeformt sind, die eine elektrische Isolierung zwischen der Bodenplatte (4) und dem jeweiligen Anschluß (7) bewirken.

14. Bus-Transceiver nach Anspruch 12 oder 13, **dadurch gekennzeichnet, daß** die Bodenplatte (4) außerdem engere zweite Bohrungen (6) aufweist, in die solche Anschlüsse (7) paßgenau - und damit elektrisch kontaktierend - eingesteckt sind, die entweder Masse-Anschlüsse sind, oder als Zusatzstifte zur Justierung und Fixierung angeordnet sind.

15. Abschirmgehäuse (1) für die Aufnahme eines Bus-Transceivers (2) einschließlich Übertrager, das einen haubenförmigen Deckel (3) aus einem magnetischen Material aufweist, **dadurch gekennzeichnet, daß** das Gehäuse (1) außerdem eine Bodenplatte (4) aus einem magnetischen Material aufweist, die elektrisch leitend mit dem Deckel (3) verbindbar ist.

16. Abschirmgehäuse (1) nach Anspruch 15, **dadurch gekennzeichnet, daß** die Bodenplatte (4) Bohrungen (5,6) zur Durchführung von Anschlüssen (7) aufweist.

17. Abschirmgehäuse (1) nach einem der Ansprüche 15 oder 16, **dadurch gekennzeichnet, daß** das magnetische Material des Gehäuses (1) ein magnetisches Stahlblech ist.

18. Abschirmgehäuse (1) nach einem der Ansprüche 15 bis 17, **dadurch gekennzeichnet, daß** der Deckel (3) und die Bodenplatte (4) verzinnt sind.

19. Abschirmgehäuse (1) nach einem der Ansprüche 15 bis 18, **dadurch gekennzeichnet, daß** der Deckel (3) und die Bodenplatte (4) aus einem Blech mit einer Dicke im Bereich von 0,1 mm bis 1,0 mm hergestellt sind.

20. Abschirmgehäuse (1) nach einem der Ansprüche 15 bis 19, **dadurch gekennzeichnet, daß** die Abmessungen der Bodenplatte (4) so gewählt sind, daß sie in den haubenförmigen Deckel (3) einsetzbar ist.
